# EUROPÄISCHE PATENTANMELDUNG

(11) **EP 1 965 439 A2**
(43) Veröffentlichungstag der Anmeldung: **03.09.2008**
(21) Anmeldenummer: 08003638.7
(22) Anmeldetag: 28.02.2008
(51) Int. Cl.: H01L 31/0236

(54) **Verfahren zur Oberflächentexturierung**

(30) Priorität: 28.02.2007 DE 102007009656; 31.07.2007 DE 102007036296
(71) Anmelder: Centrotherm Photovoltaics Technology GmbH, 89143 Blaubeuren (DE); GP Solar GmbH, 78467 Konstanz (DE)
(72) Erfinder: Fath, Peter, Dr., 78464 Konstanz (DE); Melnyk, Ihor, Dr., 78465 Konstanz (DE); Nussbaumer, Hartmut, Dr., 78479 Reichenau (DE)
(74) Vertreter: Heyerhoff, Markus

(57) **Zusammenfassung**

Verfahren zur Oberflächentexturierung, welche in industrielle Fertigungsprozesse, insbesondere in industrielle Solarzellenfertigungsprozesse, integrierbar sind; ein solches Verfahren umfasst insbesondere die Verfahrensschritte des Aufbringens (112) einer ganzflächigen Maskierung (45) auf eine zu texturierende Oberfläche (2), des Ausbildens eines Maskierungsnetzes (47) durch lokales Öffnen (114) der gänzflächigen Maskierung (45), des Ätzens (116) der zu texturierenden Oberfläche (2), wobei diese teilweise durch das Maskierungsnetz (47) geschützt wird, und wobei die ganzflächige Maskierung (45) mittels lokalem Laserverdampfen (114) der ganzflächigen Maskierung (45) geöffnet wird.

## Beschreibung

Die Erfindung betrifft Verfahren zur Oberflächentexturierung sowie Vorrichtungen zur Durchführung dieser Verfahren.

In vielen technischen Bereichen besteht Bedarf, Oberflächen aufzurauen, um beispielsweise die Oberfläche zu vergrößern. Darüber hinaus werden Oberflächentexturierungen eingesetzt, um die Lichtauskopplung bei lichtemittierenden Objekten, beispielsweise Scheinwerfern, in einen gewissen Raumwinkelbereich zu streuen. Umgekehrt werden Oberflächentexturierungen eingesetzt, um die Lichteinkopplung in Objekte zu verbessern, d. h. die Reflexion des einfallenden Lichts an der Oberfläche zu verringern.

Letzteres ist eine weit verbreitete Möglichkeit, um bei Solarzellen die Reflexion einfallenden Lichts an deren Oberfläche zu verringern und hierdurch den Wirkungsgrad der Solarzellen zu verbessern.

Silizium stellt gegenwärtig das im Photovoltaik-Bereich am häufigsten eingesetzte Ausgangsmaterial für die Solarzellenfertigung dar. Dieses reflektiert im Spektralbereich von 300 bis 1 100 nm in Abhängigkeit von der Oberflächebeschaffenheit der Siliziumscheibe bis zu 60 % des einfallenden Lichts. Eine Verringerung dieser Reflexion bewirkt daher eine spürbare Verbesserung des Wirkungsgrades. Entsprechend des lichtempfindlichen Spektralbereiches gewöhnlicher Siliziumsolarzellen von etwa 300 bis 1100 nm besteht hier vorwiegend Interesse daran, die Reflexion in diesem Wellenlängenbereich zu verringern. Die erfindungsgemäßen Verfahren sind jedoch auch außerhalb dieses Bereiches einsetzbar.

In der industriellen Fertigung von Siliziumsolarzellen, insbesondere mono- oder multikristallinen Siliziumsolarzellen, wird daher gegenwärtig eine Kombination einer Oberflächentexturierung und einer Antireflexionsbeschichtung eingesetzt. Im Falle monokristallinen Siliziums als Ausgangsmaterial wird dabei die Oberflächentextux-für gewöhnlich mit Hilfe einer nasschemischen Ätzlösung ausgebildet, welche die Oberfläche in Abhängigkeit von der Kristallorientierung anisotrop ätzt. Hierdurch können pyramidenähnliche Strukturen auf der Oberfläche ausgebildet werden, welche eine Verringerung der Reflexion bewirken. Diese Pyramiden sind von unterschiedlicher Größe und Form, weshalb in diesem Zusammenhang häufig von "zufälligen Pyramiden+" oder "randomized pyramids" die Rede ist. Die Qualität der Pyramidenstruktur hinsichtlich der Reflexionsverringerung ist hierbei neben den Parametern der Ätzlösung auch von der Ätzgeschwindigkeit abhängig. Eine zufriedenstellende Reflexionsverringerung wird üblicherweise erst bei einem vergleichsweise langsamem Ätzen erzielt, sodass der Ätzvorgang üblicherweise 30 bis 40 min. dauert.

Die Texturierung multikristallinen Siliziums erfolgt in der industriellen Fertigung gegenwärtig meist ebenfalls mittels eines nasschemischen Ätzverfahrens. Da bei multikristallinem Silizium jedoch verschiedenste Kornorientierungen vorliegen, können pyramidale Strukturen nur in Ausnahmefällen ausgebildet werden. Aus diesem Grunde werden Ätzlösungen eingesetzt, welche mit Kristalldefekten behaftete Bereiche der Siliziumoberfläche schneller ätzen als defektfreie Oberflächenbereiche. Hierdurch wird eine gewisse Oberflächenrauigkeit bzw. Oberflächentexturierung erzielt, deren Reflexionsreduktion jedoch i. d. R. hinter der einer pyramidalen Struktur hoher Qualität bei monokristallinen Silizium zurückbleibt.

Aus der Solarzellenforschung im Labormaßstab ist bekannt, dass die Reflexion einfallenden Lichts an der Solarzellenoberfläche dadurch weitergehend verringert werden kann, dass auf der Oberfläche regelmäßig angeordnete invertierte Pyramiden im Wesentlichen gleicher Gestalt und Dimensionierung angeordnet werden. Die Herstellung einer solchen Struktur erfolgt, in dem zunächst ein ätzresistenter Lack auf die zu texturierende Oberfläche aufgebracht wird. Mittels Photolithografie wird auf diesem Lack ein Maskierungsnetz definiert derart, dass in einem nachfolgenden Entwicklungsschritt ein Maskierungsnetz aus ätzresistentem Lack auf der zu texturierenden Oberfläche verbleibt, welches Öffnungen aufweist. Diese Öffnungen sind derart dimensioniert, dass bei einem nachfolgenden Texturätzen mit einer anisotropen Ätzlösung in jeder dieser Öffnungen eine invertierte Pyramide ausgebildet wird. Die Reflexionsverringerung durch die invertierten Pyramiden ist dabei umso größer, _ je dichter diese auf der zu texturierenden Oberfläche angeordnet sind.

Ein derartiges Maskierungsnetz ermöglicht auch bei multikristallinem Silizium eine Verringerung der Reflexion, die jedoch nicht das Ausmaß wie bei monokristallinem Silizium erreicht, da i. d. R. nicht flächendeckend i,nvertierte Pyramidenstrukturen ausgebildet werden können (siehe oben).

Dieses verfahren ist zwar grundsätzlich einer industriellen Fertigung nicht vorenthalten, doch ist es sehr aufwändig und findet daher keine Anwendung.

Der vorliegenden Erfindung liegt daher die Aufgabe zu Grunde, ein Verfahren zur Verfügung zu stellen, mit welchem aufwandsgünstig Oberflächentexturierungen ausgebildet werden können, welche eine gegenüber den einleitend beschriebenen rein zufälligen Texturierungen verbesserte Reduktion der Reflexion ermöglichen.

Diese Aufgabe wird gelöst durch das Verfahren mit den Merkmalen des Anspruchs 1, das Verfahren mit den Merkmalen des Anspruchs 4, das Verfahren mit den Merkmalen des Anspruchs 9, das Verfahren mit den Merkmalen des Anspruchs 12, das Verfahren mit den Merkmalen des Anspruchs 25 sowie das Verfahren mit den Merkmalen des Anspruchs 34.

Vorteilhafte Weiterbildungen sind jeweils Gegenstand abhängiger Unteransprüche.

Weiterhin befasst sich die Erfindung damit, Vorrichtungen zur Durchführung der genannten Verfahren zur Verfügung zu stellen. Dies wird realisiert durch eine Vorrichtung mit den Merkmalen des Anspruchs 42. Vorteilhafte Ausgestaltungen sind wiederum Gegenstand abhängiger Unteransprüche. '

Vorrichtungen zur Durchführung eines erfindungsgemäßen Verfahrens weisen vorzugsweise eine Steuereinrichtung auf, mittels welcher die Vorrichtung gemäß diesem Verfahren ansteuerbar ist. Die Steuereinrichtung kann aus mehreren Steuereinheiten gebildet sein.

Im folgenden wird die Erfindung anhand von Figuren näher erläutert. In diesen sind gleichwirkende Elemente, soweit zweckmäßig, mit gleichen Bezugszeichen versehen. Es zeigen:
- Fig. 1a: Ein Ausführungsbeispiel eines aufgedruckten Maskierungsnetzes.
- Fig. 1b: Ein weiteres Ausführungsbeispiel eines aufgedruckten Maskierungsnetzes.
- Fig. 2a: Gewöhnliches Ätzen der zu texturierenden Oberfläche in Öffnungen des Maskierungsnetzes.
- Fig. 2b: Unterätzen des Maskierungsnetzes.
- Fig. 3: Aufbringen eines Maskierungsnetzes mittels Trockentransferelektrofotografie mit Hilfe einer Transfertrommel.
- Fig. 4a/4b: Aufbringen eines Maskierungsnetzes mittels Trockentransferelektrofotografie mit Hilfe einer Stempelplatte.
- Fig. 5a/5b: Aufbringen eines Maskierungsnetzes unter Ausbildung eines elektromagnetischen Feldes.
- Fig. 6: Ausbilden eines Maskierungsnetzes durch eine ganz flächige Maskierung, welche lokal mittels Laserverdampfen geöffnet wird.
- Fig. 7a-7c: Ausbilden eines Maskierungsnetzes durch Einbetten von Resonanzpartikeln in eine zunächst ganzflächige Maskierung und anschließendes Entfernen der Resonanzpartikel.
- Fig. 8a/8b: Lokales Ätzen der zu texturierenden Oberfläche durch lokales Aufbringen einer Ätzlösung mittels eines Tintenstrahldruckverfahrens.
- Fig. 9: Lokales Schädigen der zu texturierenden 4berfläche.
- Fig. 10a: Lokales Schädigen der zu texturierenden Oberfläche mittels Laserstrahlung.
- Fig. 10b: Schnelleres Ätzen der geschädigten Oberflächenbereiche.
- Fig. 11a: Ausbilden eines Maskierungsnetzes unter Verwendung akustischer Wellen.
- Fig. 11b: Ausbilden eines Maskierungsnetzes unter Verwendung elektromagnetischer Wellen.

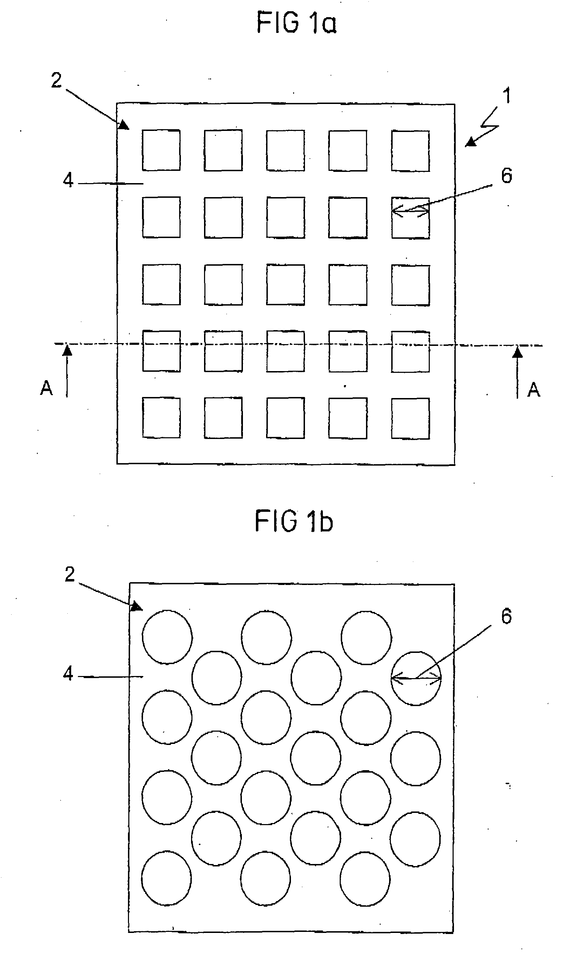

Fig. 1a illustriert ein erstes Ausführungsbeispiel eines erfindungsgemäßen Verfahrens. Hierbei wird zunächst ein ätzresistentes Maskierungsnetz 4 auf eine zu texturierende Oberfläche 2 aufgedruckt. Die zu texturierende Oberfläche wird im vorliegenden Ausführungsbeispiel durch eine großflächige Seite einer Siliziumscheibe 1 gebildet, doch kann es sich bei diesem wie auch allen nachfolgenden Ausführungsbeispielen grundsätzlich auch um ein alternatives Objekt handeln, dessen Oberfläche zu texturieren ist.

Das Drucken des ätzresistenten Maskierungsnetzes 4 kann grundsätzlich mittels jedes beliebigen Druckverfahrens, insbesondere mittels Sieb-, Rollen oder Spritzendruck erfolgen. Die Wahl des Druckverfahrens kann dabei u. a. von der geometrischen Gestalt des Maskierungsnetzes 4 abhängen. So dürfte das in dem Ausführungsbeispiel der Fig. 1b dargestellte Maskierungsnetz.4 mittels eines Spritzendrucks aufgrund der kreisförmigen Öffnungen nur schwer herzustellen sein. Hier wäre ein Siebdruckverfahren vorzuziehen. Bei dem Maskierungsnetz des Ausführungsbeispiels Fig. 1a wäre hingegen der Einsatz eines Spritzendrucks denkbar.

Im Ausführungsbeispiel der Fig. 1a weist das Maskierungsnetz 4 quadratische Öffnungen auf, im Ausführungsbeispiel der Fig. 1b hingegen kreisförmige Öffnungen. Grundsätzlich sind jedoch auch die jeweils invertierten Strukturen denkbar, d.h. dass in" den Figuren 1a und 1b die quadratischen und kreisförmigen Öffnungen das Maskierungsnetz bilden und Ätzmedien auf die dazwischen liegenden Bereiche einwirken können. Im Weiteren wird jedoch der Einfachheit halber stets davon ausgegangen, dass es sich bei den quadratischen und kreisförmigen Strukturen der Figuren 1a und 1b um Öffnungen handelt.

Die Größe dieser Öffnungen des Maskierungsnetzes 4 wird im folgenden stets als Maschenweite 6 bezeichnet. Es hat sich gezeigt, dass sich eine verringerte Reflexion vor allem mit Maschenweiten in einem Bereich von 0,7 und 20 µm erzielen lässt. Besonders verringerte Reflexionen werden mit Maschenweiten in einem Bereich von 0,7 und 10 µm erreicht. Dies gilt sowohl für die in den Fig. 1a und 1b dargestellten Maskierungsnetze 4, sowie die Maskierungsnetze der weiter unten beschriebenen Ausführungsbeispiele.

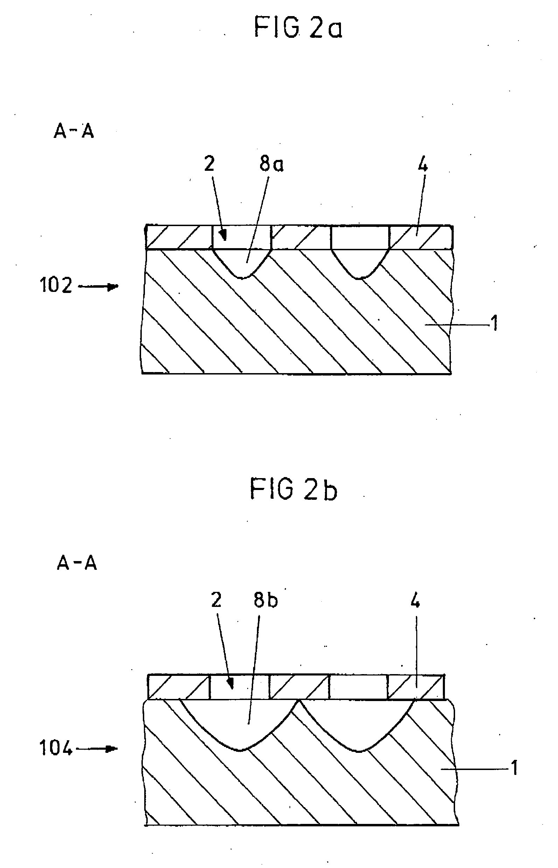

Fig. 2a illustriert das Ätzen 102 der zu texturierenden Oberfläche 2 durch das Maskierungsnetz hindurch. Zu diesem Zweck ist ein Teilschnitt entlang der Linie A-A aus der Fig. 1a in. der Fig. 2a schematisch widergegeben. Wie hierin erkennbar ist, gelangt eine eingesetzte Ätzlösung durch die Öffnungen des Maskierungsnetzes hindurch mit der zu texturierenden Oberfläche 2 in Kontakt, so dass in denjenigen Bereichen, in welchen die zu texturierende Oberfläche 2 nicht durch das Maskierungsnetz geschützt ist, Ätzkuhlen 8a ausgebildet werden.

Die Reflexion einer texturierten Oberfläche fällt umso geringer aus, je näher die Öffnungen des Maskierungsnetzes beieinander liegen. Es ist daher wünschenswert, Maskierungsnetze auszubilden, bei welchen die Öffnungen nur geringfügig voneinander beabstandet sind. Dies bedingt sehr fein strukturierte Maskierungsnetze. Insbesondere beim Einsätz von. Druckverfahren ist die Feinheit durch das Zerfließen eingesetzter Pasten und die Feinheit der eingesetzten Siebe bzw. der Spritzenkanülen begrenzt. Dem kann durch ein zumindest teilweises Unterätzen 104 des Maskierungsnetzes 4 begegnet werden, wie dies in dem Teilschnitt der Fig. 2b schematisch wiedergegeben ist. Wie dieser entnommen werden kann, hinterlässt die Ätzlösung hier nicht eine Ätzkuhle 8b, welche lateral auf den unterhalb der Öffnung gelegenen Bereich der zu texturierenden Oberfläche 2 beschränkt ist. Stattdessen bewirkt die Ätzlösung auch einen Materialabtrag in lateraler Richtung, so dass das Maskierungsnetz teilweise unterätzt ist. Eine solche laterale Ausdehnung der Ätzkuhlen 8b lässt sich häufig durch eine verlängerte Ätzzeit realisieren.

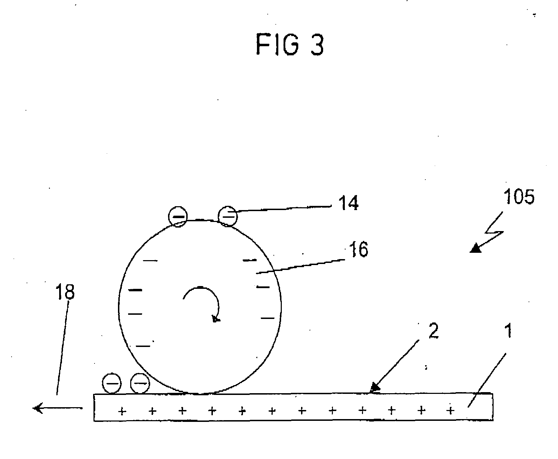

Bei dem in der Fig. 3 dargestellten Ausführungsbeispiel der Erfindung wird ein ätzresistentes Maskierungsnetz auf die zu texturierende Oberfläche 2 mittels Trockentransferelektrofotografie aufgebracht. Diese Technologie ist auch als Xerox-Verfahren bekannt und wird in Kopiergeräten oder Laserdruckern verwendet. Das Grundprinzip beruht darauf, dass geladene Partikel, ursprünglich Tonerpartikel- vorliegend ätzresistente Partikel 14, auf ein Objekt übertragen werden. Dies kann beispielsweise mittels einer elektrostatisch aufladbaren Trommel 16 erfolgen, wie sie auch in Kopierern und Laserdruckern eingesetzt wird. Das Aufbringen 105 eines Maskierungsnetzes mittels einer solchen geladenen Trommel 16 illustriert Fig. 3.

Hierbei wird die Trommel 16 elektrostatisch aufgeladen, vorzugsweise mittels einer Hochspannung. In dem in Fig. 3 dargestellten Ausführungsbeispiel sind die ätzresistenten Partikel 14 negativ geladen, so dass auch die Trommel 16 lokal negative Aufladungen aufweist. Die Trommel 16 wird dabei nicht ganzflächig geladen. Negative Ladungen werden auf der Trommel nur dort angebracht, wo sich keine ätzresistenten Partikel anlagern sollen. Diese werden dort aufgrund gleichnamiger Ladungen abgestoßen. Im weiteren wird die so mit geladenen Partikeln 14 versehene Trommel auf der zu texturierenden Oberfläche 2 abgerollt. Dabei kann entweder die Trommel 16 eine Translationsbewegung ausführen oder, wie im Beispiel der Fig. 3 durch die Bewegungsrichtung 18 der Siliziumscheibe 1 angedeutet, das zu texturierende Objekt. Die Siliziumscheibe, beziehungsweise das zu texturierende Objekt allgemein, ist dabei an der zu texturierenden Oberfläche mit positiven Ladungen versehen, so dass aufgrund elektrostatischer Anziehungskräfte die zuvor an der Trommel 16 haftenden Partikel 14 auf die zu texturierende Oberfläche 2 übertragen werden. Die Ladungen können dabei offensichtlich vertauscht werden, so dass in einem anderen Ausführungsbeispiel die Trommel sowie die ätzresistenten Partikel positiv aufzuladen werden, die zu texturierende Oberfläche hingegen negativ.

In einem Folgeschritt werden die auf die zu texturierende Oberfläche 2 übertragenden ätzresistenten Partikel 14 auf der Oberfläche fixiert. Dies kann, in Analogie zu der Trockentransferelektrografie, durch Einbrennen der Partikel auf die Oberfläche geschehen, beispielsweise in einem Durchlaufofen.

Daneben besteht auch die Möglichkeit, die Partikel 14 durch jegliche Art des Bondens zu fixieren.

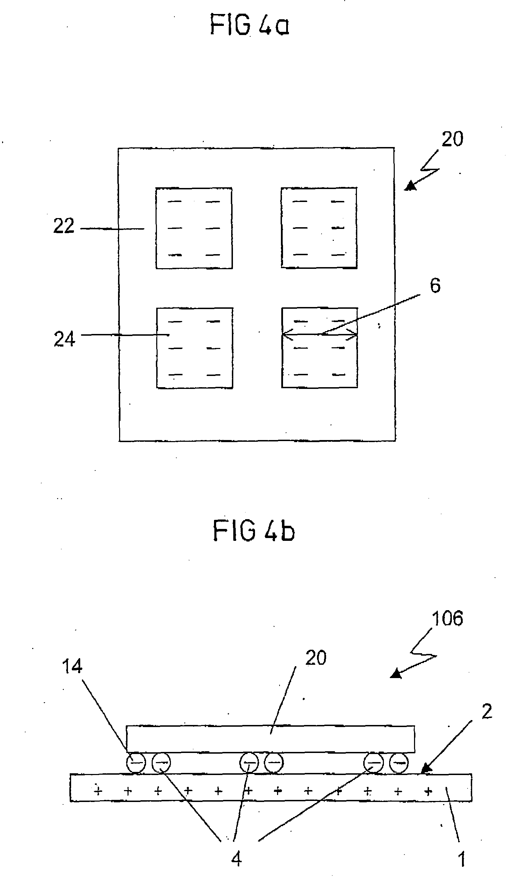

Die Fig. 4a, 4b illustrieren eine weitere Ausgestaltungsvariante des erfindungsgemäßen Verfahrens, bei welchem das Maskierungsnetz mittels Trockentransferelektrofotografie ausgebildet wird. Statt einer Trommel ist hier eine Stempelplatte 20 vorgesehen, welche zumindest eine aufladbare Seitenfläche 22 aufweist. Diese wird an denjenigen Stellen, an welchen später die Ätzlösung mit der zu texturierenden Oberfläche in Kontakt kommen soll, lokal elektrostatisch aufgeladen, beispielsweise mittels einer Hochspannung. Diese Bereiche sind in der Ausgestaltungsvariante der Fig. 4a und 4b im Wesentlichen quadratisch ausgebildet und werden im folgenden als geladene Bereiche 24 bezeichnet.

Das Aufbringen 106 des Maskierungsnetzes auf die zu texturierende Oberfläche 2 illustriert Fig. 4b. Diese zeigt die Stempelplatte 20 aus Fig. 4a, welche nun mit ihrer aufladbaren Seitenfläche 22 der zu texturierenden Oberfläche 2 zumindest so weit angenähert wird, dass aufgrund der elektrostatischen Kräfte zwischen den negativ geladenen Partikeln 14 und der positiv geladenen zu texturierenden Oberfläche 2 der Siliziumscheibe 1 ein Übergang der geladenen Partikel 14 auf die zu texturierende Oberfläche 2 stattfindet. Die übertragenen geladenen Partikel 14 bilden dabei das Maskierungsnetz 4 aus. Dieses wird vorzugsweise durch nachfolgendes Einbrennen der Partikel 14 in die zu texturierende Oberfläche 2 oder durch Bonden der Partikel 14 mit der zu texturierenden Oberfläche 2 fixiert.

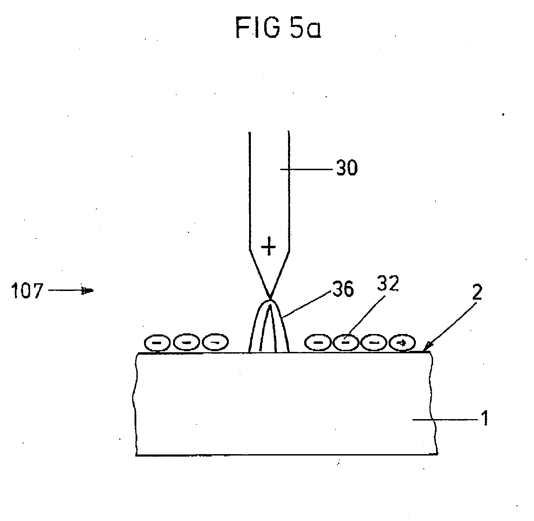

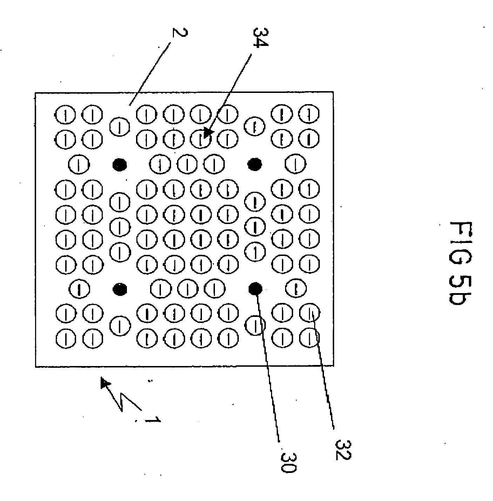

Ein weiteres Ausführungsbeispiel des erfindungsgemäßen Verfahrens illustriert Fig. 5a .Hier wird ein elektromagnetisches Feld in Form eines elektrischen Feldes 36 derart über der zu texturierenden Oberfläche 2 ausgebildet, dass eine in das Feld 36 eingebrachte ätzresistente Substanz 32, welche in der Ausgestaltungsvariante der Fig. 5a durch ätzresistente Partikel gebildet ist, durch wechselwirkung mit dem Feld 36 ein Maskierungsnetz 34 ausbildet, welches in Fig. 5b schematisch wiedergegeben ist. In dieser Darstellung ist die ätzresistente Substanz durch Partikel gebildet. Diese können zur zusätzlichen Fixierung auf die zu texturierende Oberfläche 2 gebondet oder in diese eingebrannt werden. Abgesehen von den durch das elektrische Feld 36 freigehaltenen Bereichen bildet die ätzresistente Substanz ein dichtes Maskierungsnetz aus. Anstelle ätzresistenter Partikel 32 kann als ätzresistente Substanz 32 auch eine Flüssigkeit vorgesehen sein. Besonders bevorzugt werden ätzresistente Substanzen eingesetzt, welche elektrisch aufladbare und ätzresistente Polymere enthalten.

Bei den in den Figuren 3 bis 5b dargestellten erfindungsgemäßen Verfahren kann das Ätzen in den Öffnungen der Maskierungsnetze 4 in einer der Weisen erfolgen, wie sie im Zusammenhang mit den Figuren 2a und 2b beschrieben sind. Insbesondere kann auch hier ein teilweises Unterätzen der Maskierungsnetze vorgesehen sein.

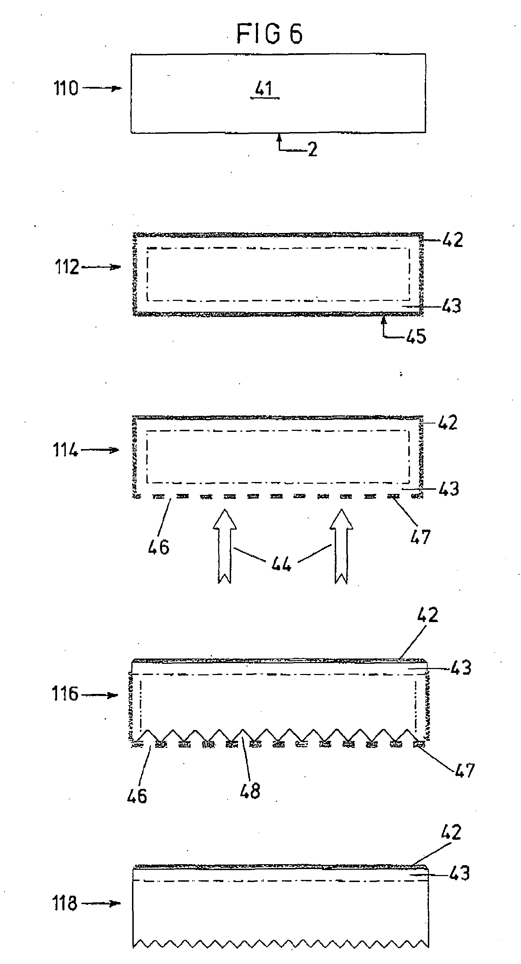

Ein weiteres erfindungsgemäßes Verfahren illustriert Figur 6 schematisch anhand des Beispieles einer Oberflächentexturierung einer Solarzelle bzw. einer Siliziumscheibe 41. Diese Siliziumscheibe 41 wird, wie bei der Solarzellcnherstellung üblich, zunächst gereinigt 110. Dies erfolgt für gewöhnlich durch Überätzen der Siliziumoberfläche und ggf. weitere nasschemische Reinigungsschritte. Die zu texturierende Oberfläche 2 wird in diesem Fall durch die Unterseite der Siliziumscheibe 41 gebildet. In einem Folgeschritt wird die Siliziumscheibe 41 einer Bordiffusion 112 unterzogen. Hierbei wird neben einem Bor-diffundierten Bereich 43 ein Borglas 42 ausgebildet, welches eine ganzflächige Maskierung 45 der zu texturierenden Oberfläche 2, d. h. der Unterseite der Siliziumscheibe 41, darstellt. Auf diese Weise kann gleichzeitig ein für die Funktion der Solarzelle wesentlicher Bor-diffundierter Bereich 43 sowie die ganzflächige Maskierung 45 ausgebildet werden, da Borglas gegenüber einigen zum Ätzen von Silizium einsetzbaren Ätzlösungen resistent ist.

Zur Ausbildung eines Maskierungsnetzes 47 wird das Borglas 42 im Folgenden im Bereich der ganzflächigen Maskierung 45 lokal verdampft 114. Das resultierende Maskierungsnetz 47 kann grundsätzlich eine beliebige geometrische Struktur aufweisen, insbesondere sind geometrische Ausgestaltungen in Analogie zu den in den Figuren 1a und 1b dargestellten denkbar. Im Ausführungsbeispiel der Fig. 6 erfolgt das Verdampfen mittels Laserstrahlung 44, welche von unten auf die ganzflächige Maskierung 45 gerichtet wird. Umgibt das Borglas 42 die Siliziumscheibe 41 nicht vollständig, beispielsweise weil nur unterseitig die ganzflächige Maskierung 45 aus Borglas aufgebracht ist, z.B. durch Bonden, kann die Laserstrahlung 44 auch zunächst durch die Siliziumscheibe 41 geführt werden, ehe sie von der Siliziumscheibe aus auf die ganzflächige Maskierung 45 trifft und diese lokal verdampft, sodass wiederum ein Maskierungsnetz ausgebildet wird.

Im Weiteren wird zumindest die Unterseite der Siliziumscheibe 41, an welcher mittels der Laserstrahlung 44 Öffnungen 46 gebildet worden sind, einer Ätzlösung ausgesetzt. Handelt es sich bei der Siliziumscheibe 41 um monokristallines Silizium, so wird vorzugsweise eine anisotrope Ätzlösung eingesetzt, mittels welcher sich durch Ätzen 116 der zu texturierenden Siliziumoberfläche 2 durch die Öffnungen 46 hindurch invertierte Pyramiden 48 ausbilden lassen. Wie der Figur 6 entnommen werden kann, wird dabei das Maskierungsnetz teilweise unterätzt, wie dies näher im Zusammenhang mit Fig. 2b beschrieben wurde. Dies ist jedoch nicht grundsätzlich erforderlich, da mittels der eingesetzten Laserstrahlung 44 sich für gewöhnlich hinreichend feine Strukturen des Maskierungsnetzes 47 ausbilden lassen. Vorzugsweise kommt hierbei ein CO₂-Laser zum Einsatz.

Bei der Solarzellenfertigung wird im Weiteren das Borglas zumindest teilweise entfernt 118, insbesondere im Bereich der texturierten Oberfläche. Die weiteren Verfahrensschritte zur Solarzellenfertigung sind bekannt, sodass auf deren Erläuterung an dieser Stelle verzichtet werden kann.

Die ganzflächige Maskierung 45 kann alternativ anstatt durch eine Bordiffusion auch auf andere Weise aufgebracht werden. Beispielsweise kann ein entsprechendes Material aus einer Gasphase chemisch abgeschieden werden (CVD-Abscheidung). Dabei kann es sich um eine Plasma-unterstützte Abscheidung handeln oder auch um eine Abscheidung bei niedrigem Druck oder Atmosphärendruck. Insbesondere ist es denkbar, auf diese Weise Oxide, vorzugsweise Siliziumoxid, Nitride oder Carbide auf der zu texturierenden Oberfläche abzuscheiden. Daneben können entsprechende Materialien auch auf die zu texturierende Oberfläche 2 durch Bonden aufgebracht werden, vorzugsweise durch anodisches Bonden. Weiterhin können Oxide als ganzflächige Maskierung auf die Siliziumscheibe 41 oder andere zu texturierende Oberflächen aufgebracht werden. Im Fall von Siliziumdioxid kann dies bspw. in einem Quarzrohrofen unter Zufuhr von Sauerstoff erfolgen.

Daneben besteht die Möglichkeit, die ganzflächige Maskierung durch ein Druckverfahren, insbesondere Sieb-, Spritz- oder Rollendruck, auf die zu texturierende Oberfläche aufzubringen. Auch ein Aufspinnen einer entsprechenden Lösung ist denkbar.

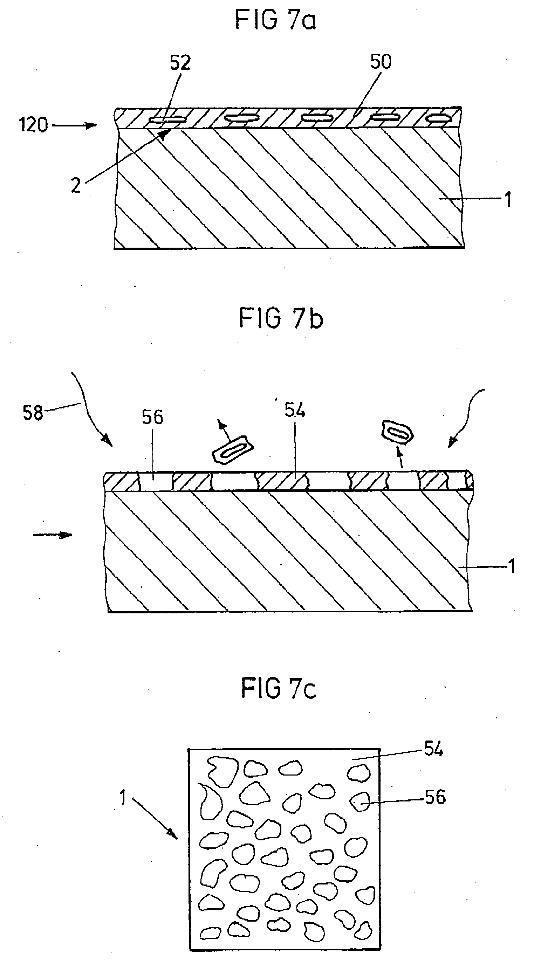

Alle genannten Möglichkeiten zur Ausbildung der ganzflächigen Maskierung können auch im Ausführungsbeispiel der Figuren 7a bis 7c Verwendung finden. So kann die ganzflächige Maskierung 50 bspw. auf die zu texturierende Oberfläche 2 der Siliziumscheibe 1, bzw. eines sonstigen zu texturierenden Objekts, aufgesponnen werden 120; die aufgesponnene Lösung weist dabei Resonanzpartikel 52 auf, welche vorzugsweise homogen auf der zu texturierenden Oberfläche 2 verteilt angeordnet werden. Im Weiteren werden die lokal in die ganzflächige Maskierung 50 eingebetteten Resonanzpartikel 52 durch Einstrahlung 122 einer elektromagnetischen Strahlung 58 entfernt. Die elektromagnetische Strahlung 58 weist hierzu eine Frequenz auf, mittels welcher die Resonanzpartikel 52 zu Schwingungen angeregt werden. Der Energieeintrag durch die elektromagnetische Strahlung 58 wird dabei derart gewählt, dass die Resonanzpartikel derart stark in Schwingung geraten, dass sie aus der ganzflächigen Maskierung 50 herausbrechen, wie dies in Fig. 7b schematisch angedeutet ist. In Folge dessen verbleiben Öffnungen 56 in der ganzflächigen Maskierung 50, sodass ein Maskierungsnetz 54 ausgebildet wird, welches in einer Draufsicht in der Figur 7c illustriert ist. Durch die Öffnungen 56 hindurch kann wiederum ein Ätzen der zu texturierenden Oberfläche erfolgen, wie es u. a. in Verbindung mit den Figuren 2a und 2b beschrieben wurde. Handelt es sich bei dem zu ätzenden Objekt um einen Gegenstand aus monokristallinem Silizium, so findet vorzugsweise eine anisotrope Ätzlösung Verwendung, welche die Ausbildung invertierter Pyramiden ermöglicht. Hierbei kann es sich um eine Ätzlösung handeln, welche Kaliumhydroxid und Isopropylalkohol aufweist. Wie im Falle aller anderen bisher beschriebenen erfindungsgemäßen Verfahren kann als Ätzmedium auch ein ätzendes Plasma Verwendung finden.

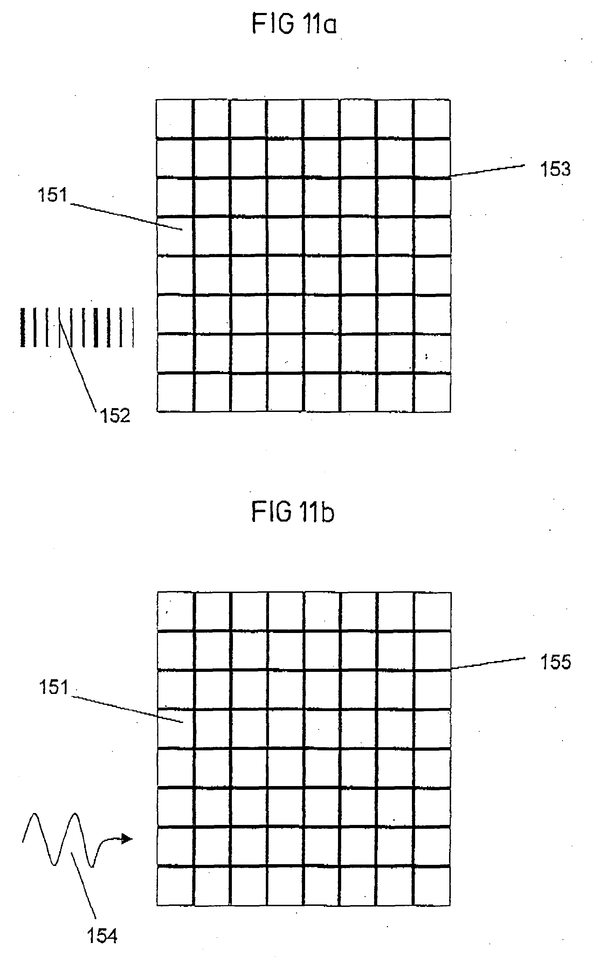

Weitere Verfahren gemäß der Erfindung sind schematisch in den Figuren 11a und 11b dargestellt. Figur 11a zeigt eine Siliziumscheibe 151, auf deren zu texturierender Oberfläche zunächst ätzresistente Partikel aufgebracht werden. Im weiteren wird die Siliziumscheibe zu mechanischen Schwingungen angeregt, beispielsweise durch Einstrahlung einer oder mehrerer geeigneter akustischer Wellen 152. Dabei wird eine solche Schwingungsmode ausgewählt, dass die ätzresistenten Partikel sich, in gleicher Weise wie bei der Ausbildung Chladnischer Klangfiguren, auf der Siliziumscheibe in den Schwingungsknoten bzw. den Schwingungsknotenlinien der Schwingungsmode der Siliziumscheibe anordnen und hierdurch ein Maskierungsnetz 153 ausbilden.

Bei einem weiteren erfindungsgemäßen Verfahren wird an Stelle der akustischen Welle 152 ein elektromagnetisches Feld genutzt. Dies illustriert schematisch Figur 11b. wiederum werden zunächst auf die Siliziumscheibe 151 ätzresistente Partikel aufgebracht, die in diesem Fall zudem in der Lage sind mit einem elektromagnetischen Feld in Wechselwirkung zu treten. Sie tragen daher beispielsweise eine elektrische Ladung oder ein magnetisches Moment. Im Weiteren wird über der Siliziumscheibe, bzw. über deren zu texturierenden Oberfläche, eine elektromagnetische Feldstruktur ausgebildet. Dies erfolgt durch Einstrahlen einer oder mehrerer elektromagnetischer Wellen 154, wie dies in Figur 11b schematisch angedeutet ist. In Folge dieser eingestrahlten elektromagnetischen Wellen wird über der zu texturierenden Oberfläche eine elektromagnetische Feldstruktur ausgebildet, mit welcher die ätzresistenten Partikel derart in Wechselwirkung treten, dass sie ein Maskierungsnetz 155 ausbilden.

In Figur 11a ist die Schwingung der Siliziumscheibe, in Figur 11b die elektromagnetische Feldstruktur nicht explizit dargestellt. Die Schwingung der Siliziumscheibe wie auch die elektromagnetische Feldstruktur sind jedoch anhand ihrer jeweiligen Wechselwirkungen mit den ätzresistenten Partikeln erkennbar, auf Grund welcher die Maskierungsnetze 153 und 155 ausgebildet werden. Nach Ausbildung dieser Maskierungsnetze 153, 155 werden diese auf der zu texturierenden Oberfläche der Siliziumscheibe 151 fixiert. Dies kann beispielsweise durch Einsintern oder Bonden der Partikel erfolgen. Im Weiteren wird die Siliziumscheibe 151 durch die von dem Maskierungsnetz 153 bzw. 155 gebildeten Öffnungen hindurch geätzt, wie es u.a. bereits in Verbindung mit den Figuren 2a und 2b oder 7a bis 7c beschrieben wurde und die Oberfläche hierdurch texturiert.

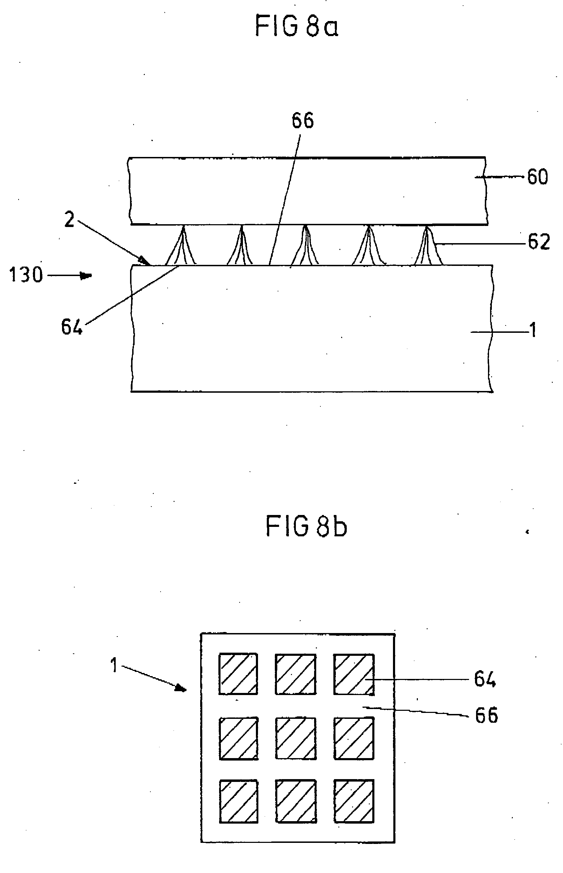

Die Figuren 8a und 8b illustrieren ein weiteres Verfahren gemäß der Erfindung. Bei diesem wird ein Ätzmedium 62 an mehreren Ätzstellen 64 lokal mit einer zu texturierenden Oberfläche 2 derart in Berührung gebracht, dass zwischen benachbarten Ätzstellen 64 Bereiche 66 zu der zu texturierenden Oberfläche 2 verbleiben, welche nicht mit dem Ätzmedium 62 in Berührung gelangen. Wie der Darstellung der Fig. 8a zu entnehmen ist, kann dies bspw. dadurch realisiert werden, dass als Ätzmedium eine Ätzflüssigkeit 62 eingesetzt wird, welche mittels eines Tintenstrahldruckverfahrens auf die Ätzstellen 64 aufgebracht wird 130. Unter Tintenstrahldruckverfahren werden dabei Verfahren verstanden, wie sie bei Tintenstrahldruckern eingesetzt werden. Üblicherweise werden hierbei piezoelektrische Düsen eingesetzt, welche eine genaue Verteilung der Tinte bzw. der Ätzflüssigkeit auf dem Papier bzw. der zu texturierenden Oberfläche 2 ermöglichen. Unter Bezugnahme auf diese Analogie ist der die Düsen für die Ätzlösung bzw. Ätzflüssigkeit 62 enthaltene Kopf 60 in der Fig. 8a als Druckkopf bezeichnet.

Diese Technologie ist jedoch nicht zwingend auf den Einsatz einer Ätzflüssigkeit beschränkt. So kann das Verfahren auch auf den Einsatz reaktiver Gase übertragen werden, welche mittels in dem Druckkopf 60 angeordneter Düsen lokal auf Ätzstellen 64 der zu texturierenden Oberfläche 2 geleitet werden.

Fig. 8b illustriert schematisch in einer Draufsicht beispielhaft, wie die mittels einer Ätzflüssigkeit oder eines ätzenden Gases ausgebildeten Ätzstellen 64 und die zugehörigen Bereiche ohne Berührung mit dem Ätzmedium 66 ausgestaltet sein können.

In Analogie zu der Maschenweite der Maskierungsnetze hat sich gezeigt, dass die Ätzstellen 64 zweckmäßigerweise derart ausgestaltet sind, dass sie sich entlang der zu texturierenden Oberfläche 2 in jeder Richtung in einer Länge erstrecken, die in einem Bereich von 0,7 bis 20 nm liegt.

Im Fall von zu texturierendem monokristallinem Silizium werden wiederum vorzugsweise anisotrop ätzende Ätzmediem eingesetzt, bspw. Ätzlösungen, welche Kaliumhydroxid und Isopropylalkohol enthalten. Wie bei allen übrigen vorbeschriebenen Ausgestaltungsvarianten der Erfindung sind jedoch auch andere Ätzlösungen denkbar, bspw. im Falle von zu ätzendem Silizium solche, welche Flusssäure und Salpetersäure enthalten, vorzugsweise zusätzlich auch Wasser. Eine solche Ätzlösung wird besonders bevorzugt bei multikristallinem Silizium eingesetzt.

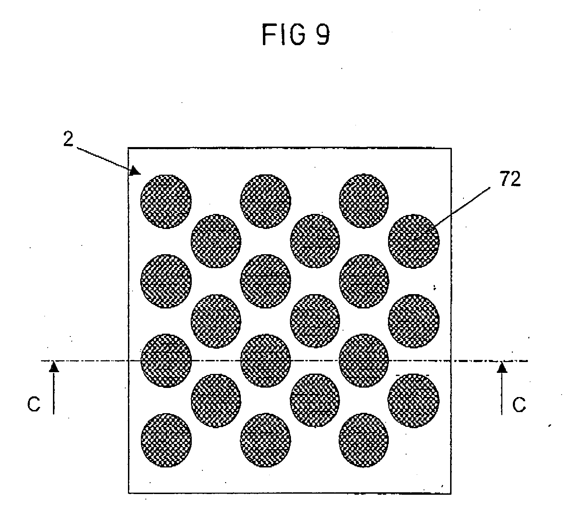

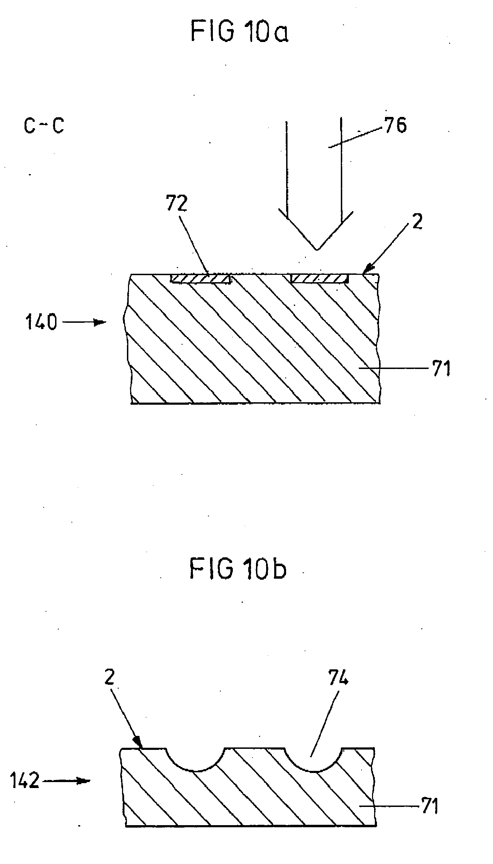

Die Figuren 9, 10a und 10b illustrieren eine weitere Ausgestaltungsvariante eines erfindungsgemäßen Verfahrens. Bei dieser wird die zu texturierende Oberfläche 2 zunächst lokal geschädigt 140. Im Weiteren wird die zu texturierende Oberfläche 2 mit einem Ätzmedium geätzt 142, welches beschädigte Stellen schneller ätzt als ungeschädigte. Fig. 9 illustriert an einem Beispiel, wie die lokal beschädigten Stellen 72 auf der zu texturierenden Oberfläche 2 verteilt sein können. Das lokale Schädigen 140 der zu texturierenden Oberfläche 2 kann bspw. mittels Laserstrahlung 76 erfolgen, wie dies schematisch in Fig. 10a angedeutet ist, aber auch auf andere Weise wie 2.B. lokalen Beschuss mit harten Partikeln wie Siliziumcarbidpartikeln. Im dargestellten Ausführungsbeispiel der Fig. 10a wird mittels dieser Laserstrahlung die zu texturierende Oberfläche 2 einer Siliziumscheibe 71 beschädigt, indem das in dem lasergeschädigten Bereich 72 ursprünglich vorhandene intakte Kristallgefüge durch lokales Verdampfen beschädigt wird. Fig. 10b illustriert, wie sich diese Schädigungen in einem nachfolgenden Ätzschritt 142 mit einem Ätzmedium, welches beschädigte Stellen schneller ätzt, auswirken.

Wie man dieser Darstellung entnimmt, ist durch Einwirkung eines Ätzmediums, bspw. einer Ätzlösung, über die gesamte zu texturierende Oberfläche 2 der Siliziumscheibe 71 hinweg ein Materialabtrag erfolgt. Dieser war in den lasergeschädigten Bereichen 72 jedoch stärker ausgeprägt, sodass sich dort Ätzkuhlen 74 gebildet haben, welche in ihrer Gesamtheit eine Oberflächentextur darstellen. Die Ätzkuhlen 74 können dabei variierende geometrische Gestalt aufweisen. Dies ist von der Kristallorientierung in der Siliziumscheibe 71 und auch von deren Oberflächenbeschaffenheit abhängig. Insbesondere mit, wie zu Reinigungszwecken teilweise üblich, Fluß- und Salpetersäure glanzgeätzte Siliziumscheiben erfahren an ihrer Oberfläche einen vergleichsweise geringen Materialabtrag durch das Ätzen, sodass die Unterschiede im Materialabtrag zwischen ungeschädigten und geschädigten Bereichen stärker ausfallen als bei Siliziumscheiben mit anderen Oberflächen. Infolgedessen weisen die Ätzkuhlen andere geometrische Formen auf als bei anderweitig oder gar nicht vorbehandelten Siliziumscheiben. Aus diesem Grund hat sich dieses erfindungsgemäße Verfahren für glanzgeätzte Siliziumscheiben als besonders geeignet erwiesen. Die geschädigten Stellen wirken hier gleichsam als Ätzkeime, an welchen das Ätzmedium angreifen kann.

Als Ätzmedium kommt in dem Ausführungsbeispiel der Figuren 9, 10a und 10b vorzugsweise eine Ätzlösung zum Einsatz, welche Flusssäure und Salpetersäure enthält. Besonders bevorzugt enthält sie zusätzlich Wasser.

Die Ausgestaltungsvariante des erfindungsgemäßen Verfahrens nach den Figuren 9, 10a, und 10b

Ein weiteres Ausführungsbeispiel der Erfindung sieht vor, dass die zu texturierende Oberfläche in eine Ätzlösung eingebracht wird. In dieser Ätzlösung wird ein Gasstrom aus einem Gas ausgebildet, welches nicht mit Bestandteilen der Ätzlösung reagiert. Diesem Inertgasstrom wird eine Struktur in Form eines Maskierungsnetzes aufgeprägt. Dies kann bspw. dadurch erfolgen, dass eine Vielzahl von Düsen derart angeordnet wird, dass sie in der Summe ein Maskierungsnetz ausbilden, sodass die Summe der auf die zu texturierende Oberfläche geführten Gasströmungen aus den verschiedenen Düsen die Struktur eines Maskierungsnetzes bilden. Die Gasströmung verhindert, dass an diesen Stellen die zu texturierende Oberfläche mit der Ätzlösung in Kontakt tritt. In den übrigen Bereichen hingegen, in welchen kein Inertgas auf die zu texturierende Oberfläche geführt wird, tritt diese mit der Ätzlösung in Kontakt und es erfolgt ein Texturätzen unter Ausbildung von Ätzkuhlen.

Eine andere Möglichkeit zur Ausbildung einer solchen Gasströmung, die gleichsam eine Art Gasdusche darstellt, besteht darin, einen vergleichsweise breit gefächerten Gasstrom, welcher die gesamte zu texturierende Oberfläche abzudecken vermag, mit einer Blende zu versehen, die ein Negativabbild des Maskierungsnetzes darstellt. Durch die Öffnungen der Blende gelangt dann das Gas an die zu texturierende Oberfläche und schirmt die entsprechenden Bereiche gegenüber der Ätzlösung ab. Infolgedessen ergibt sich auch hier eine Oberflächentextur, welche in den nicht abgeschirmten Bereichen Ätzkuhlen aufweist.

Sämtliche Ausgestaltungsvarianten der Erfindung können vorteilhaft zum Texturieren einer Halbleiteroberfläche verwendet werden, insbesondere zum Texturieren einer Siliziumoberfläche. Die erfindungsgemäßen Verfahren können daher besonders vorteilhaft in industriellen Fertigungsprozessen von Solarzellen, und vor allem industrielle Solarzellenfertigungsprözesse, integriert werden, um die Reflexion der Solarzellenoberfläche zu verringern und damit die Lichteinkopplung und den Wirkungsgrad zu verbessern. Solarzellen, welche eine Oberfläche aufweisen, die zumindest teilweise nach einem der erfindungsgemäßen Verfahren texturiert ist, weisen daher bei vergleichsweise geringem Fertigungsaufwand einen höheren wirkungsgrad auf.

### Bezugszeichenliste

- 1: Siliziumscheibe
- 2: zu texturierende Oberfläche
- 4: Maskierungsnetz
- 6: Maschenweite
- 8a: Ätzkuhle
- 8b: Ätzkuhle
- 14.: geladene Partikel
- 16: geladene Trommel
- 18: Bewegungsrichtung Siliziumscheibe
- 20: Stempelplatte
- 22: aufladbare Seitenfläche
- 24: geladener Bereich
- 30: Elektrode
- 32: geladene Partikel
- 34: Maskierungsnetz
- 36: elektrisches Feld
- 41: Siliziumscheibe
- 42: Borglas
- 43: Bor-diffundierter Bereich
- 44: Laserstrahlen
- 45: ganzflächige Maskierung
- 46: Öffnung
- 47: Maskierungsnetz
- 48: invertierte Pyramide
- 50: ganzflächige Maskierung
- 52: Resonanzpartikel
- 54: Maskierungsnetz
- 56: Öffnung
- 58: elektromagnetische Strahlung
- 60: Druckkopf
- 62: Ätzflüssigkeit
- 64: Ätzstelle
- 66: Bereich ohne Berührung mit Ätzflüssigkeit
- 71: Siliziumscheibe
- 72: lasergeschädigter Bereich
- 74: Ätzkuhle
- 76: Laserstrahlung
- 102: Ätzen zu texturierende Oberfläche
- 104: Unterätzen
- 105: Aufbringen Maskierungsnetz
- 106: Aufbringen Maskierungsnetz
- 107: Ausbilden elektrisches Feld
- 110: Ätzen / Reinigen
- 112: Bordiffusion
- 114: lokales Laserverdampfen
- 116: Ätzen
- 118: Borglas entfernen
- 120: Aufspinnen Maskierung
- 122: elektromagnetische Strahlung einstrahlen
- 130: Bedrucken mit Ätzflüssigkeit
- 140: Schädigen Oberfläche
- 142: Ätzen
- 151: Siliziumscheibe
- 152: akustische welle
- 153: Maskierungsnetz
- 154: elektromagnetische Welle
- 155: Maskierungsnetz

## Patentansprüche

1. Verfahren zur Oberflächentexturierung mit folgenden Verfahrensschritten:
- Drucken eines ätzresistenten Maskierungsnetzes (4) auf eine zu texturierende Oberfläche (2);
- Ätzen (102;104) der zu texturierenden Oberfläche (2), wobei diese teilweise durch das Maskierungsnetz (4) geschützt wird.

2. Verfahren nach Anspruch 1,
**dadurch gekennzeichnet, dass**
das Maskierungsnetz (4) zumindest teilweise unterätzt wird (104).

3. Verfahren nach einem der Ansprüche 1, bis 2,
**dadurch gekennzeichnet,dass**
das Drucken des ätzresistenten Maskierungsnetzes (4) mittels Sieb-, Rollen- oder Spritzendruck erfolgt.

4. verfahren zur Oberflächentexturierung mit folgenden Verfahrensschritten:
Aufbringen (105; 106) eines ätzresistenten Maskierungsnetzes (4) auf eine zu texturierende Oberfläche (2) mittels Trockcntrar_sferelektrofotografie; . '
- Ätzen (102; 104)der zu texturierenden Oberfläche (2), wobei diese teilweise durch das Maskierungsnetz (4) geschützt wird.

5. Verfahren nach Anspruch 4,
**dadurch gekennzeichnet , dass**
bei der Trockentransferelektrografie eine elektrostatisch aufladbare Trommel (16) eingesetzt wird (105), mit welcher ätzresistente Partikel (14) auf die zu texturierende Oberfläche (2) übertragen werden (105).

6. Verfahren nach Anspruch 4,
**dadurch gekennzeichnet,dass**
bei der Trockentransferelektrografie eine Einrichtung (20) mit wenigstens einer elektrostatisch aufladbaren, im Wesentlichen ebenen Seitenfläche (22) eingesetzt wird, mittels welcher ätzresistente Partikel (14) auf die zu texturierende Oberfläche (2) übertragen werden.

7. Verfahren nach einem der Ansprüche 4 bis 6,
**dadurch gekennzeichnet,dass**
auf die zu texturierende Oberfläche (2) übertragene ätzresistente Partikel in die zu texturierende Oberfläche eingebrannt werden.

8. Verfahren nach einem der Ansprüche 4 bis 6,
**dadurch gekennzeichnet, dass**
auf die zu texturierende Oberfläche (2) übertragene ätzresistente Partikel (14) durch Bonden, vorzugsweise anodisches Bonden, mit der zu texturierenden Oberfläche (2) verbunden werden.

9. Verfahren zur Oberflächentexturierung mit folgenden Verfahrensschritten:
- Ausbilden (107) eines elektromagnetischen Feldes (36) über einer zu texturierenden Oberfläche (2) derart, dass eine in das Feld (36) eingebrachte ätzresistente Substanz (32) durch Wechselwirkung mit dem Feld (36) ein Maskierungsnetz (34)ausbildet;
- Ätzen der zu texturierenden Oberfläche (2), wobei diese teilweise durch das Maskierungsnetz (34) geschützt wird.

10. Verfahren nach Anspruch 9,
**dadurch gekennzeichnet,dass**
die ätzresistente Substanz (32) elektrisch geladene Partikel (32) aufweist, welche ätzresistent sind.

11. Verfahren nach einem der Ansprüche 9 bis 10,
**dadurch gekennzeichnet,dass**
die ätzresistente Substanz (14) wenigstens ein elektrisch geladenes und ätzresistentes Polymer aufweist.

12. Verfahren zur Oberflächentexturierung mit folgenden Verfahrensschritten:
- Aufbringen (112) einer ganzflächigen Maskierung (45) auf eine zu texturierende Oberfläche (2);
- Ausbilden eines Maskierungsnetzes (47) durch lokales Öffnen (114) der ganzflächigen Maskierung (45);
- Ätzen (116) der zu texturierenden Oberfläche (2), wobei diese teilweise durch das Maskierungsnetz (47) geschützt wird;
**dadurch gekennzeichnet,dass**
die ganzflächige Maskierung (45) mittels lokalem Laserverdampfen (114) der ganzflächigen Maskierung (45) geöffnet wird.

13. Verfahren zur Oberflächentexturierung mit folgenden Verfahrensschritten:
- Aufbringen (120) einer ganzflächigen Maskierung (50) auf eine zu texturierende Oberfläche (2);
- Ausbilden eines Maskierungsnetzes (54) durch lokales Öffnen (122) der ganzflächigen Maskierung (50);
- Ätzen (105; 106) der zu texturierenden Oberfläche (2), wobei diese teilweise durch das Maskierungsnetz (54) geschützt wird;
**dadurch gekennzeichnet,dass**
- bei dem Aufbringen (120) der ganzflächigen Maskierung (50) lokal Resonanzpartikel (52) in diese eingebettet werden (120);
- die ganzflächige Maskierung (50) einer elektromagnetischen Strahlung (58) einer derartigen Frequenz ausgesetzt wird (122), dass die Resonanzpartikel zu Schwingungen angeregt werden;
- der Energieeintrag durch die elektromagnetische Strahlung (58) in die Resonanzpartikel (52) derart gewählt wird, dass Resonanzpartikel (52) aus der ganzflächigen Maskierung (50) heraus gelöst werden (122), sodass lokal Öffnungen (56) in der ganzflächigen Maskierung (50) entstehen.

14. Verfahren nach Anspruch 13,
**dadurch gekennzeichnet , dass**
die Resonanzpartikel (52) homogen in der ganzflächigen Maskierung (50) verteilt werden.

15. Verfahren nach einem der Ansprüche 12 bis 14,
**dadurch gekennzeichnet,dass**
die ganzflächige Maskierung (50) mittels Sieb-, Rollen-oder Spritzendrucken oder Aufspinnen (120) einer ätzresistenten Paste (50) aufgebracht wird.

16. Verfahren nach einem der Ansprüche 12 bis 14,
**dadurch gekennzeichnet,dass**
die ganzflächige Maskierung (50) durch chemisches Abscheiden ätzresistenten Materials aus einer Gasphase aufgebracht wird, wobei die Abscheidung vorzugsweise bei Atmosphärendruck durchgeführt wird.

17. Verfahren nach einem der Ansprüche 12 bis 14,
**dadurch gekennzeichnet, dass**
die ganzflächige Maskierung (50) durch Bonden von ätzresistentem Material (50) auf die zu texturierende Oberfläche (2) aufgebracht wird, vorzugsweise durch anodisches Bonden.

18. Verfahren nach einem der Ansprüche 12 bis 14,
**dadurch gekennzeichnet,dass**
zur Ausbildung der ganzflächigen Maskierung (45) eine Substanz mit der zu texturierende Oberfläche (2) in Kontakt gebracht wird (112), welches mit der zu texturierenden Oberfläche (2) unter Bildung eines ätzresistenten Materials (42) reagiert.

19. Verfahren nach Anspruch 18,
**dadurch gekennzeichnet , dass**
zur Bildung des ätzresistenten Materials (42) Energie zugeführt wird, vorzugsweise durch Erhitzen der zu texturierenden Oberfläche (2) und/oder der aufgebrachten Substanz, vorzugsweise in einem Durchlaufofen.

20. Verfahren nach einem der Ansprüche 18 bis 19,
**dadurch gekennzeichnet,dass**
die Substanz durch Sieb-, Spritzen-, Rollendrucken oder Aufspinnen auf die zu texturierende Oberfläche (2) aufgebracht wird.

21. Verfahren nach einem der Ansprüche 18 bis 19,
**dadurch gekennzeichnet, dass**
die Substanz mittels eines Gasflusses auf die zu texturierende Oberfläche (2) aufgebracht wird (112), wobei die zu texturierende Oberfläche (2) vorzugsweise in einem Diffusionsofen angeordnet und von dem Gasfluss umspült wird.

22. Verfahren nach einem der Ansprüche 18 bis 21,
**dadurch gekennzeichnet, dass**
eine Bor in elementarer oder chemisch gebundener Form enthaltende Substanz verwendet wird (112).

23. Verfahren nach einem der Ansprüche 16 bis 22,
**dadurch gekennzeichnet, dass**
Borglas (42), ein Oxid, vorzugsweise Siliziumdioxid, ein Carbid oder ein Nitrid als ätzresistentes Material (42,45,50) aufgebracht wird (112; 120).

24. Verfahren zur Oberflächentexturierung mit folgenden Verfahrensschritten:
- Aufbringen ätzresistenter Partikel auf eine zu texturierende Oberfläche;
- Anregen der zu texturierenden Oberfläche zu einer mechanischen Schwingung derart, dass die ätzresistenten Partikel sich in Knoten bzw. Knotenlinien der Schwingung sammeln und ein Maskierungsnetz ausbilden;
- Fixieren der ätzresistenten Partikel auf der zu texturierenden Oberfläche;
- Ätzen der zu texturierenden Oberfläche.

25. Verfahren zur Oberflächentexturierung mit folgenden Verfahrensschritten:
- Aufbringen ätzresistenter, mit einem elektromagnetischen Feld in Wechselwirkung tretender Partikel auf eine zu texturierende Oberfläche;
- Ausbilden einer elektromagnetischen Feldstruktur über der zu texturierenden Oberfläche derart, dass die ätzresistenten Partikel in Folge ihrer Wechselwirkung mit der elektromagnetischen Feldstruktur auf der zu texturierenden Oberfläche ein Maskierungsnetz ausbilden;
- Fixieren der ätzresistenten Partikel auf der zu texturierenden Oberfläche;
- Ätzen der zu texturierenden Oberfläche.

26. Verfahren nach einem der Ansprüche 24 bis 25,
**dadurch gekennzeichnet , dass** die ätzresistenten Partikel durch Sintern oder Bonden auf der zu texturierenden Oberfläche fixiert werden.

27. Verfahren nach einem der Ansprüche 1 bis 26
**dadurch gekennzeichnet,dass**
das Maskierungsnetz (4; 34; 47; 54) mit einer Maschenweite (6) in einem Bereich zwischen 0,7 und 20 µm ausgbildet wird, vorzugsweise in einem Bereich zwischen 0,7 und 10 µm.

28. Verfahren zur Oberflächentexturierung, bei welchem ein Ätzmedium (62) an mehreren Ätzstellen (64) lokal mit einer zu texturierenden Oberfläche (2) derart in Berührung gebracht wird (130), dass zwischen benachbarten Ätzstellen (64) Bereiche (66) der zu texturierenden Oberfläche (2) verbleiben, welche nicht mit dem Ätzmedium (62) in Berührung gelangen.

29. Verfahren nach Anspruch 28,
**dadurch gekennzeichnet,dass**
jeder der verbleibenden Bereiche (66) auf der zu texturierenden Oberfläche (2) eine kleinere Flächenausdehnung besitzt als jede der Ätzstellen (64).

30. Verfahren nach einem der Ansprüche 28 bis 29,
**dadurch gekennzeichnet,dass**
die Ätzstellen (64) sich entlang der zu texturierenden Oberfläche (2) in jeder Richtung über eine Länge erstrecken, die in einem Bereich von 0,7 bis 20 µm liegt.

31. Verfahren nach einem der Ansprüche 28 bis 30,
**dadurch gekennzeichnet,dass**
als Ätzmedium (62) eine Flüssigkeit (62) mittels eines Tintenstrahldruckverfahrens auf die Ätzstellen (64) aufgebracht wird (130).

32. Verfahren nach einem der Ansprüche 28 bis 30,
**dadurch gekennzeichnet , dass**
als Ätzmedium (62) ein Gas auf die Ätzstellen geleitet wird.

33. Verfahren nach einem der Ansprüche 1 bis 32,
**dadurch gekennzeichnet , dass** zum Ätzen (105; 106; 116) der zu texturierenden Oberfläche (2) eine anisotrope Ätzlösung verwendet wird, vorzugsweise eine Kaliumhydroxid und Isopropylalkohol enthaltende Ätzlösung.

34. Verfahren nach einem der Ansprüche 1 bis 32,
**dadurch gekennzeichnet , dass**
das Ätzen (105; 106; 116) der zu texturierenden Oberfläche (2) durch Plasmaätzen erfolgt.

35. Verfahren nach einem der Ansprüche 33 bis 34,
**dadurch gekennzeichnet , dass**
durch das Ätzen (116) in der zu texturierenden Oberfläche (2) invertierte Pyramiden (48) ausgebildet werden.

36. Verfahren nach einem der Ansprüche 1 bis 32,
**dadurch gekennzeichnet,dass**
als Ätzmedium eine Ätzlösung verwendet wird, welche Flusssäure und Salpetersäure enthält, vorzugsweise zusätzlich Wasser.

37. Verfahren zur Oberflächentexturierung mit folgenden Verfahrensschritten:
- lokales Schädigen (140) der zu texturierenden Oberfläche (2);
- Ätzen (142) der zu texturierenden Oberfläche (2) mit einem Ätzmedium, welches beschädigte Stellen schneller ätzt als unbeschädigte.

38. Verfahren nach Anspruch 37,
**dadurch gekennzeichnet,dass**
die zu texturierende Oberfläche (2) mittels Laserstrahlung (76) lokal beschädigt wird (140).

39. Verfahren nach einem der Ansprüche 37 bis 38,
**dadurch gekennzeichnet,dass**
als Ätzmedium eine Ätzlösung verwendet wird, welche Flusssäure, Salpetersäure und Wasser enthält.

40. Verwendung eines Verfahrens nach einem der Ansprüche 1 bis 39 zum Texturieren einer Halbleiteroberfläche (2).

41. Verwendung nach Anspruch 40,
**dadurch gekennzeichnet , dass**
eine Siliziumoberfläche (2) texturiert wird.

42. Vorrichtung aufweisend Mittel zur Durchführung eines Verfahrens nach einem der Ansprüche 1 bis 39.

43. Vorrichtung nach Anspruch 42,
**gekennzeichnet durch**
eine Steuereinrichtung zur Ansteuerung der Vorrichtung gemäß einem Verfahren nach einem der Ansprüche 1 bis 41.

44. Vorrichtung nach Anspruch 42,
**dadurch gekennzeichnet,dass** als ein Mittel zur Durchführung des Verfahrens nach Anspruch 6 eine Einrichtung (20) mit wenigstens einer elektrostatisch aufladbaren, im Wesentlichen ebenen Seitenfläche vorgesehen ist.

45. Vorrichtung nach Anspruch 42,
**dadurch gekennzeichnet,dass** dass als Mittel zur Durchführung des Verfahrens nach einem der Ansprüche 8 bis 10 wenigstens eine Elektrode (30) und ätzresistente, elektrisch geladene Partikel (32) vorgesehen sind.

46. Vorrichtung nach Anspruch 42,
**dadurch gekennzeichnet,dass** als Mittel zur Durchführung des Verfahrens nach Anspruch 13 eine elektromagnetische Strahlungsquelle und Resonanzpartikel (53) vorgesehen sind, wobei mittels der elektromagnetischen Strahlungsquelle elektromagnetische Strahlung in der Resonanzfrequenz Resonanzpartikel (52) emittierbar ist.

47. Solarzelle aufweisend eine Oberfläche, die mit einem Verfahren nach einem der Ansprüche 1 bis 39 texturiert ist.
